# EUROPEAN PATENT SPECIFICATION

(11) **EP 4 348 361 B1**
(45) Date of publication and mention of the grant of the patent: **07.05.2025**
(21) Application number: 22764359.0
(22) Date of filing: 08.08.2022
(51) Int. Cl.: G05B 17/02, G05B 19/418

(54) **COMPUTER-IMPLEMENTED METHOD AND ORCHESTRATION SYSTEM TO ORCHESTRATE CONFIGURATIONS OF SIMULATIONS BASED ON DIGITAL TWIN MODELS OF MODULAR PLANTS**
COMPUTERIMPLEMENTIERTES VERFAHREN UND ORCHESTRIERUNGSSYSTEM ZUR ORCHESTRIERUNG VON KONFIGURATIONEN VON SIMULATIONEN AUF DER BASIS VON DIGITALEN ZWILLINGSMODELLEN VON MODULAREN ANLAGEN
PROCÉDÉ ET SYSTÈME D'ORCHESTRATION MIS EN OEUVRE PAR ORDINATEUR POUR ORCHESTRER DES CONFIGURATIONS DE SIMULATIONS BASÉES SUR DES MODÈLES JUMEAUX NUMÉRIQUES D'INSTALLATIONS MODULAIRES

(30) Priority: 09.08.2021 EP 21190289
(43) Date of publication of application: 10.04.2024
(73) Proprietor: Siemens Aktiengesellschaft, 80333 München (DE)
(72) Inventor: BOTERO HALBLAUB, Andrés, 85614 Kirchseeon (DE); GÖTZ, Jan, 91054 Buckenhof (DE); HELD, Harald, 85461 Bockhorn (DE)
(74) Representative: Siemens Patent Attorneys
(86) International application number: PCT/EP2022/072185
(87) International publication number: WO 2023/016960

(56) References cited:
- EP-A1- 3 696 636
- WO-A1-2019/099111
- HATLEDAL LARS IVAR ET AL: "A Language and Platform Independent Co-Simulation Framework Based on the Functional Mock-Up Interface", IEEE ACCESS, vol. 7, 15 August 2019 (2019-08-15), pages 109328 - 109339, XP011740814, DOI: 10.1109/ACCESS.2019.2933275

## Description

The invention refers to a computer-implemented method to orchestrate configurations of simulations based on digital twin models of modular plants according to the preamble of claim 1 and an orchestration system to orchestrate configurations of simulations based on a digital twin models of modular plants according to the preamble of claim 3.

Plants of various technical domains - such as industry domain (e.g., metal or chemical processing industry), medical domain, energy domain, telecommunication domain, etc. - are becoming more and more modular and plant owners delegate their tasks to machine suppliers, who deliver modular machines with all automation and analytics functionalities embedded.

For a plant owner there are vendor agnostic solutions for the integration of the automation - such as MTP, PackML, and many others - into an orchestration layer, but for distributed analytics and simulation on edge devices of the machine there are no existent solutions. The present patent application takes on this issue.

Regarding the distributed analytics and simulation on edge devices there are some specific problems:
- Distributed simulation is currently not supported on an edge infrastructure with the capability to access field data.
- Integration of such a distributed edge application into automation is time consuming:
   So often according to a specified Open Platform Communications Unified Architecture <OPC UA> tag per tag have to be enabled, connected and validated with cumbersome orchestration, synchronization routines have to be developed.
- Too many dependencies on hardware, software, and operating systems and on the simulation and simulation orchestration.
- Complex deployment of distributed simulations among many edge devices due to synchronization.

But even if today solutions of such applications were available, so many of needed functionalities would have been developed specifically for a single use and are thus not scalable or massively widely replicable. Furthermore, the applications have a point to point communication and synchronization with a tight vendor software dependency.

EP 3 969 636 Al discloses a method and a system for providing a virtual sensor for an industrial control system using a simulation model built in a Functional Mock-Up Interface (FMI) compliant tool.

It is an objective of the invention to propose a computer-implemented method and an orchestration system to orchestrate configurations of simulations based on digital twin models of modular plants, by which in the course of the orchestration the configurations of the model-based simulations are generated and deployed automatically.

This objective is solved with regard to a computer-implemented method defined in the preamble of claim 1 by the features in the characterizing part of claim 1.

Moreover, the objective is solved by a computer program product according to claim 2.

The objective is further solved with regard to an orchestration simulator defined in the preamble of claim 3 by the features in the characterizing part of claim 3.

The main idea of the invention according to the claims 1, 2and 3 - in order to orchestrate configurations of simulations based on digital twin models of modular plants and a logical "System Structure and Parameterization <SSP>"-functionality including a "Functional Mock-up Interface <FMI>"-functionality combined with a "Functional Mock-up Unit <FMU>"-functionality - is (i) generating for distributed operational-technology-applications of the modular plants, wherein the operational-technology-applications are edge devices of field devices, simulated model components including assignment rules for automation data captured due to automation of the plants and assigned to the distributed operational-technology-applications, (ii) deploying in the course of orchestrating the simulations configurations the simulated model components on the distributed operational-technology-applications by using the SSP-functionality with "Functional Mock-up Unit <FMU>"-functionalities as part of the FMI-functionality for the distributed operational-technology-applications and implementing for the distributed operational-technology-applications and as part of the FMI-functionality in a server-client-manner "Remote Procedure Call <RPC>"-technology based Proxy-FMU-functionalities with - "Proxy-FMU"-entities embedded in the SSP-functionality and - corresponding "Remote-Controlled-FMU"-entities implemented on the distributed operational-technology-applications and (iii) deploying the automation data on the distributed operational-technology-applications according to the assignment rules for the automation data and as a result of the deployment of the simulated model components.

Summary of used features:
- Runtime for execution of distributed digital twins on an edge infrastructure
- Abstraction layer for distributed simulations and analytics
- Incorporation of field devices and field data into the abstraction layer
- Combination of a co-simulation environment with "operational technology <OT>"-aspects on an OT-infrastructure and automation system
- Mocking of standard "Functional Mock-up Interface <FMI>" combined with a "Functional Mock-up Unit <FMU>" *(cf.* https://fmi-standard.org) access even for remote simulation components
- Automatic generation and deployment of simulation components in the OT-infrastructure

The combination of features, tools, artifacts, and elements of the Digital Enterprise are leveraged by using a distributed abstraction layer for a digital twin runtime environment.

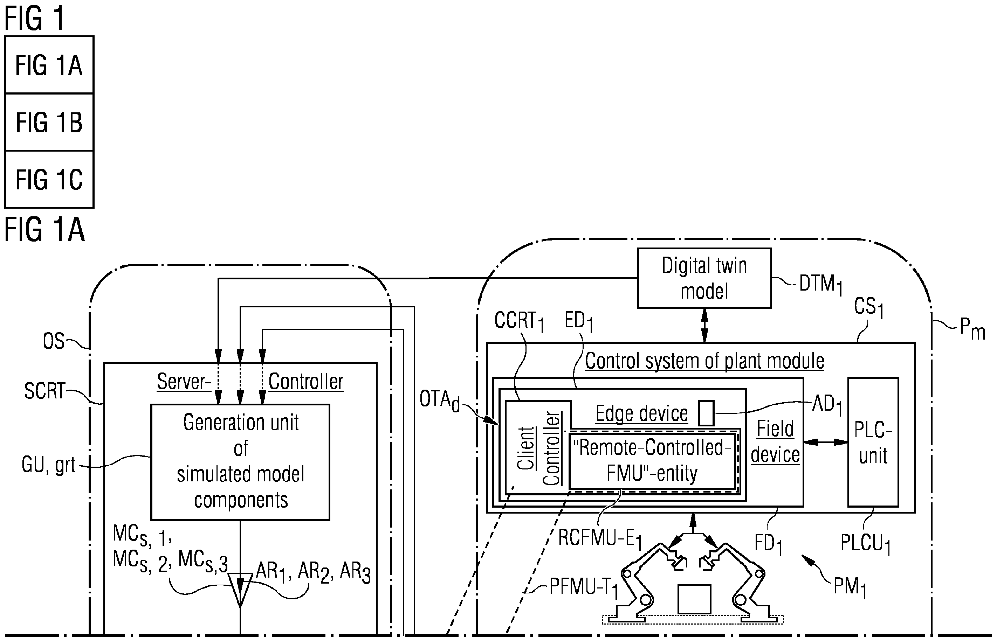

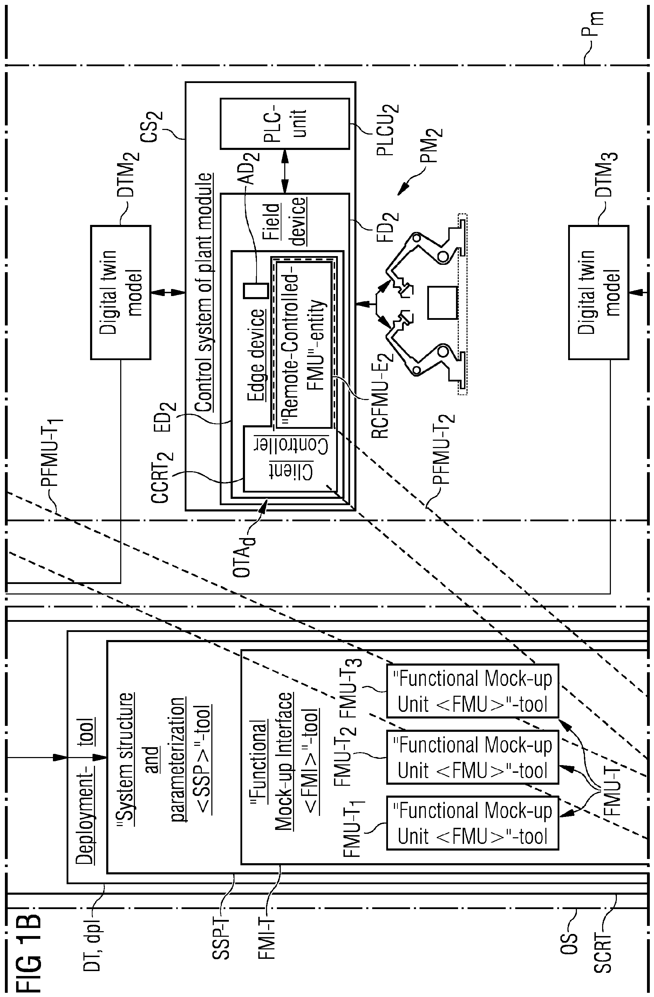

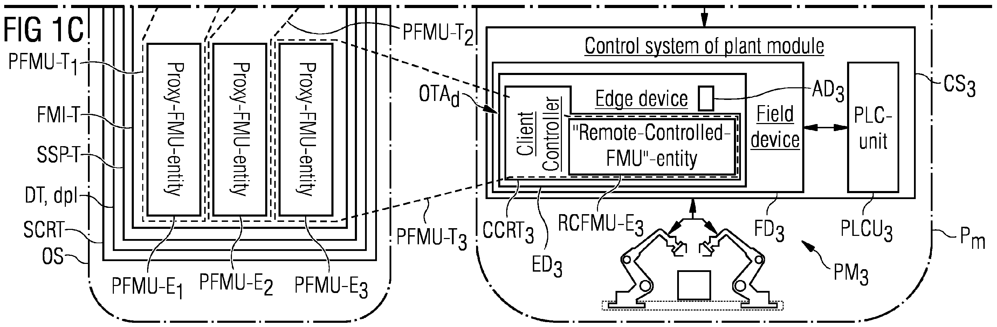

This application enables the OT-Edge to interconnect standardized simulation objects deployable on an edge device and to coordinate them through an intelligent vendor agnostic orchestrating master algorithm from any vendor *(cf.* *FIGURES 1**,* *3* *and* *4**).*

These figures show the idea how to implement and handle FMU calls to an FMU that resides on a remote machine.

For the following explanation of the idea, let us assume to have a simulation in form of an FMU called "myFmu".

### Parameterized proxy FMU on the server

The idea is to have a generic FMU that acts as a proxy to a remote one. As this proxy is also an FMU, it needs to implement all functions specified in the FMI standard. It is totally generic though in that it does not implement any actual simulation in these functions but merely RPC-calls to a remote FMU. You can think of this proxy therefore as a remote controller for any FMU.

What makes an instance of such a proxy FMU specific are essentially two things:
- an actual simulation FMU that is to be remote controlled
- a URI how to reach the remote-controlled FMU

So, given "myFmu" and the empty, generic proxy FMU "proxyFmu", a specific proxy FMU instance for "myFmu" can be generated as follows:
1. Create appropriate modelDescription.xml: The idea is that the generated proxy FMU has exactly the same input and output information as "myFmu". This is very easy to achieve by simply copying the exact same "modelDescription.xml"-file from the original FMU. No further modifications to this file are necessary.
2. Create "proxyMyFmu": An FMU is just a zip archive, so we can create a new one based on "proxyFmu" which has the previously generated "modelDescription.xml"-file added to it. Additionally, it can be added any file needed to the ZIP-archive. In particular, it is made use of that to add a configuration file to the proxy FMU's resource folder that contains information like where the remote-controlled FMU resides (i.e., its remote host name) as well as the port where the corresponding FMU remote controller listens at.

At this point, there is a valid FMU called "proxyMyFmu" that can be used like any other to orchestrate simulations in any FMU-based simulation tool/library.

The implementation of "proxyFmu" can be totally generic because all it does is essentially this:
1. It acts as an RPC-client, and upon instantiation connects to a remote RPC-server of a well-known "Remote Procedure Call <RPC>"-technology (cf. https://en.wikipedia.org/wiki/Remote procedure call in the *version of July 23, 2021)* given by a "Uniform Resource Identifier <URI>". As described before, this URI comes from a dedicated file containing it.
2. It implements all functions specified in the FMI standard, but instead of actually doing anything in these function implementations, it simply serializes the function arguments and does corresponding RPC-calls to its RPC-server. Remote-controlled FMU on a device (client)

The client side consists of a generic RPC-server part whose role is to accept incoming RPC-calls from the "proxyFmu" like "proxyMyFmu". What it does then is this:
1. Deserialize the function arguments.
2. Call the corresponding function of the actual FMU (which is just a library implementing the functions specified in the FMI standard). Note that it needs to know what the actual FMU is such that it can extract this library and dynamically load it at runtime. This information must therefore ideally come from the deployment step and can be e.g., given as an argument when starting a corresponding "Docker"-container *(cf.* https://en.wikipedia.org/wiki/Docker (software) *in the version of July 7, 2021*)*.*
3. The result of the function call is then finally sent back as the response to the RPC-request.
4. Each FMU has a defined set of inputs and outputs, each given in its "modelDescription.xml"-file by a name and a value type (e.g., integer, floating point number, Boolean, string). Orchestrating a distributed simulation that consists of individual such FMUs (no matter where or on which edge device each individual one is being executed), involves connecting such inputs and outputs. Typically, the cited modular plants involve data coming from field devices that is made available by a field bus, and such data should be part of relevant simulations in a natural way, in other words, it will enter simulation models as inputs. As a consequence, there are typically not only FMU inputs that stem from other FMUs' outputs, but they rather come in directly as (signal-) data from a field device. This is something that needs to be configured as well when the whole distributed simulation is being orchestrated. Precisely, not only do FMU inputs and outputs need to be mapped, but also automation data names to their corresponding FMU inputs. While the first kind of mapping, i.e., the input/output mapping, can be elegantly described by a standard called "System Structure & Parameterization <SSP>" (cf. https://ssp-standard.org), there is no such standard for the mapping of automation data. What we propose here is the following:
   - During the deployment process, the data mapping is generated and put inside of the remote-controlled FMU. Information within the SSP-topology file can define what field signals are expected by the FMUs. This can automate the process in many cases. This can again be a simple configuration file, such like "YAML" (cf. https://en.wikipedia.org/wiki/YAML *in the version of June 23,* 2021) put inside of the ZIP-archive.
   - The remote-control service reads this signal mapping, subscribes to the configured data names, and passes values on to the actual FMU function calls when needed. If new values are memorized as soon as they come in, passing on always the latest values to the FMU functions is guaranteed and the simple subscription model suffices.

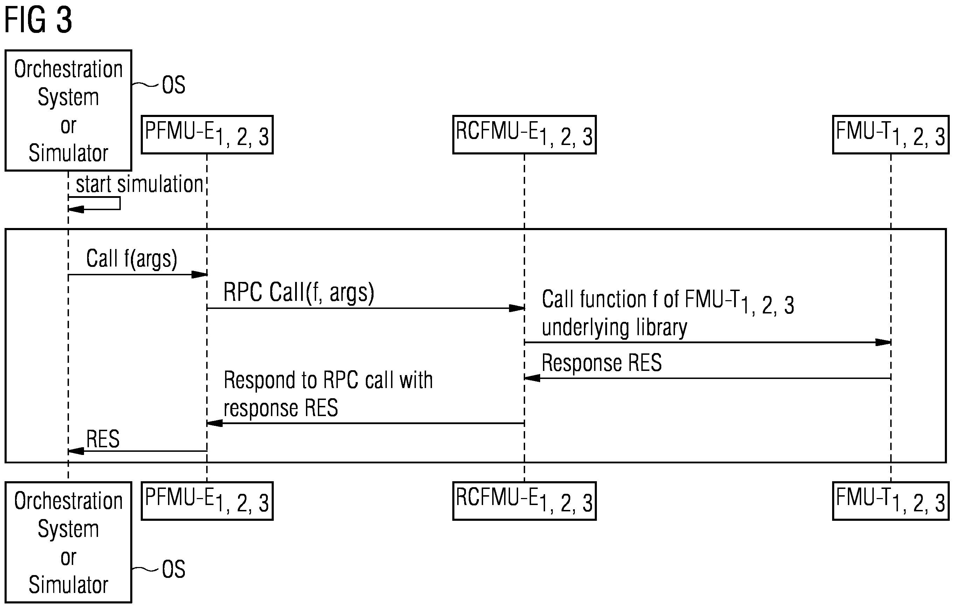

Just like the server part, the service described here (let us give it the name "fmuRemoteController" is again totally generic. An actual instance of this service only needs to know where the FMU library is such that it can call its functions *(cf.* *FIGURE 3* *shows a sequence of RPC-calls)*

The explained orchestrating system allows a distributed operational technology digital twin runtime with access to field data of modular plants to be deployed on edge devices.

Known applications have deep dependencies, have many manual extensions and are difficult to adapt for different applications.

The proposed idea abstracts all these aspects and enables simulation and analytic model suppliers to deploy their OT-systems as part of an Edge Ecosystem reducing their dependency footprint.
1. The actual RPC-technology is not that hard to exchange. The only parts that need to be adapted are the "proxyFmu" and "fmuRemoteController".
2. Instances like "proxyMyFmu" are just normal FMUs. They behave in no way differently from a simulation tool's point of view. They can be orchestrated and run like any other, and the remote calling parts are totally hidden in its internals.
3. Any simulation tool can be used; or also a library like "Amesim", "Simulink", "fmpy", "libcosim".
4. Remote FMI/FMU are automatically generated
5. FMI/FMUs are automatically deployed on corresponding (depending on field variables) OT-system
6. SSP-standard is used to connect OT-signals

Further advantageous developments of the invention are given by the independent claims.

Moreover, additional advantageous developments of the invention arise out of the following description of a preferred embodiment of the invention according to FIGURES 1 to 4. They show:
FIGURE 1 a scenario for orchestrating configurations of model-based simulations of a modular plant,
FIGURE 2 a principle presentation of a computer-implemented-tool, in particular a Computer-Program-Product, e.g., designed as an APP,
FIGURE 3 an exemplary message-flow-diagram for deploying the simulated model components by implementing in a server-client-manner "Remote Procedure Call <RPC>"-technology based Proxy-FMU-functionalities,
FIGURE 4 an exemplary orchestration flow between involved units of the "SERVER-CLIENT"-based scenario depicted in the FIGURE 1.

FIGURE 1 shows a server-client-based scenario for orchestrating configurations of model-based simulations of a plant with a modular structure Pₘ. The plant with the modular structure Pₘ includes for example as depicted three plant modules, a first plant module PM₁, a second plant module PM₂ and a third plant module PM₂, which can be regarded as modular plants. Each modular plant PM₁, PM₂, PM₃ has always the same plant structure.

So, it belongs to the first modular plant PM₁, a first control system of plant module CS₁, which is connected or assigned on one side to a first digital twin model DTM₁ and on the other to automated machines or processes, depicted in the FIGURE 1 by robots. To the first control system of plant module CS₁ belongs - in general and well-known - a first "Programmable Logic Controller <PLC>"-unit PLCU₁, which is connected with a first field device FD₁ including a first edge device ED₁. The first edge device ED₁ is in the context of the preferred embodiment of the invention a distributed operational-technology-application OTA_{d}, for which according to the objective of the invention and in the course of orchestrating the configurations of the model-based simulations are generated and deployed automatically.

The same structure have the second modular plant PM₂ and the third modular plant PM₃.

So, it belongs to the second modular plant PM₂, a second control system of plant module CS₂, which is connected or assigned on one side to a second digital twin model DTM₂ and on the other again to automated machines or processes, depicted in the FIGURE 1 by the robots. To the second control system of plant module CS₂ belongs again a second "Programmable Logic Controller <PLC>"-unit PLCU₂, which is connected with a second field device FD₂ including a second edge device ED₂. Also, the second edge device ED₂ is in the context of the preferred embodiment of the invention a distributed operational-technology-application OTA_{d}, for which according to the objective of the invention and in the course of orchestrating the configurations of the model-based simulations are generated and deployed automatically.

To the third modular plant PM₃ consequently belongs a third control system of plant module CS₃, which is connected or assigned on one side to a third digital twin model DTM₃ and on the other again to automated machines or processes, depicted in the FIGURE 1 by the robots. To the third control system of plant module CS₃ belongs a third "Programmable Logic Controller <PLC>"-unit PLCU₃, which is connected with a third field device FD₃ including a third edge device ED₃. Also, the third edge device ED₃ is in the context of the preferred embodiment of the invention again a distributed operational-technology-application OTA_{d}, for which according to the objective of the invention and in the course of orchestrating the configurations of the model-based simulations are generated and deployed automatically.

According to the FIGURE 1 the orchestration is carried out by an orchestration system OS, which is for instance in a preferred and simplest design a simulator expanded to include SSP-, FMI/FMU-functionality, to orchestrate configurations of simulations based on the digital twin models DTM₁, DTM₂, DTM₃ of the modular plants PM₁, PM₂, PM₃, which includes a server-controller SCRT to configure the model-based simulations.

According to the depicted "SERVER-CLIENT"-based scenario server-controller SCRT of the orchestration system OS is the "SERVER" and the edge devices ED₁, ED₂, ED₃ of the modular plants PM₁, PM₂, PM₃ are the "CLIENTS".

In the course of the orchestration the server-controller SCRT includes as part of a deployment tool DT a logical "System Structure and Parameterization <SSP>"-tool SSP-T, which is well-known (cf. https://ssp-standard.org) and describes in a logical way how model components for the simulations are connected and composed for their deployment into composite components and how model parameterization data are stored and exchanged between each the model component and the composite component. The logical "System Structure and Parameterization <SSP>"-tool SSP-T consist or includes a "Functional Mock-up Interface <FMI>"-tool FMI-T (cf. https://fmi-standard.org) for sharing the simulations via a "ZIP-archive"-based "Functional Mock-up Unit <FMU>"-tool FMU-T packing XML-files and compiled C-code.

Moreover in the course of the orchestration the server-controller SCRT includes a generation unit GU, which generates grt based on the digital twin models DTM₁, DTM₂, DTM₃ of the modular plants PM₁, PM₂, PM₃ and for the distributed operational-technology-applications OTA_{d} respectively the edge devices ED₁, ED₂, ED₃ of the modular plants PM₁, PM₂, PM₃ simulated model components, (i) at least one first simulated model component MC_{s,1} for the first edge device ED₁, (ii) at least one second simulated model component MC_{s,2} for the second edge device ED₂ and (iii) at least one third simulated model component MC_{s,3} for the third edge device ED₃, captured each due to automation of the modular plants PM₁, PM₂, PM₃.

For this purpose, the first simulated model component MC_{s,1} includes first assignment rules AR₁ for first automation data AD₁ assigned to the first edge device ED₁, second assignment rules AR₂ for second automation data AD₂ assigned to the second edge device ED₂ and third assignment rules AR₃ for third automation data AD₃ assigned to the third edge device ED₃.

These generated information MC_{s,1}, MC_{s,2}, MC_{s,3}, AR₁, AR₂, AR₃, AD₁, AD₂, AD₃ are transferred within the server-controller SCRT to the deployment tool DT for deploying the information on the distributed operational-technology-applications OTA_{d} respectively the edge devices ED₁, ED₂, ED₃ of the modular plants PM₁, PM₂, PM₃.

For this purpose, the deployment tool DT of the server-controller SCRT deploys dpl the simulated model components MC_{s,1}, MC_{s,2}, MC_{s,3} on the distributed operational-technology-applications OTA_{d} respectively the edge devices ED₁, ED₂, ED₃ by
- using the SSP-functionality SSP-T with "Functional Mock-up Unit <FMU>"-functionalities as part of the FMI-functionality FMI-T, (i) a first "Functional Mock-up Unit <FMU>"-functionality FMU-T₁ for the first edge device ED₁, (ii) a second "Functional Mock-up Unit <FMU>"-functionality FMU-T₂ for the second edge device ED₂ and (iii) a third "Functional Mock-up Unit <FMU>"-functionality FMU-T₃ for the first edge device ED₃, and
- implementing for the distributed operational-technology-applications OTA_{d} respectively the edge devices ED₁, ED₂, ED₃ and as part of the FMI-functionality FMI-T in a server-client-manner and based on a well-known "Remote Procedure Call <RPC>"-technology (cf. https://en.wikipedia.org/wiki/Remote procedure call in the *version of July 23, 2021)* Proxy-FMU-functionalities, (i) a first Proxy-FMU-functionality PFMU-T₁ with a first "Proxy-FMU"-entity PFMU-E₁ embedded in the SSP-functionality SSP-T of the server-controller SCRT and a corresponding first "Remote-Controlled-FMU"-entity RCFMU-E₁ implemented in a first client-controller CCRT₁ on the first edge device ED₁, which includes the first automation data AD₁ assigned to the first edge device ED₁ and to be deployed on (ii) a second Proxy-FMU-functionality PFMU-T₂ with a second "Proxy-FMU"-entity PFMU-E₂ embedded in the SSP-functionality SSP-T of the server-controller SCRT and a corresponding second "Remote-Controlled-FMU"-entity RCFMU-E₂ implemented in a second client-controller CCRT₂ on the second edge device ED₂, which includes the second automation data AD₂ assigned to the second edge device ED₂ and to be deployed on, and (iii) a third Proxy-FMU-functionality PFMU-T₃ with a third "Proxy-FMU"-entity PFMU-E₃ embedded in the SSP-functionality SSP-T of the server-controller SCRT and a corresponding third "Remote-Controlled-FMU"-entity RCFMU-E₃ implemented in a third client-controller CCRT₃ on the third edge device ED₃, which includes the third automation data AD₃ being assigned to the third edge device ED₃ and to be deployed on.

Moreover, the deployment tool DT is designed such that the automation data AD₁, AD₂, AD₃ are deployed dpl on the distributed operational-technology-applications OTA_{d} respectively the edge devices ED₁, ED₂, ED₃ according to the assignment rules AR₁, AR₂, AR₃ for the automation data AD₁, AD₂, AD₃ and as a result of the deployment dpl of the simulated model components MC_{s,1}, MC_{s,2}, MC_{s,3}.

Furthermore, the orchestration system OS can be designed as a hardware solution or realized as a software solution such that the orchestration system OS is a computer-implemented-tool CIT, which is nothing else than a Computer-Program-Product being designed preferably as an APP and which is up-loadable into the server-controller SCRT.

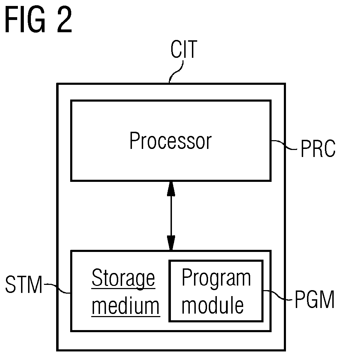

FIGURE 2 shows in a principal diagram of the computer-implemented-tool CIT how the tool could be designed. According to the depiction the computer-implemented-tool CIT includes a non-transitory, processor-readable storage medium STM having processor-readable program-instructions of a program module PGM for identifying manipulations of cyber-physical-systems stored in the non-transitory, processor-readable storage medium STM and a processor PRC connected with the storage medium STM executing the processor-readable program-instructions of the program module PGM to identify manipulations of cyber-physical-systems.

FIGURE 3 shows starting from the FIGURE 1 and based on the corresponding Figure-1-description an exemplary message-flow-diagram for deploying the simulated model components by implementing in a server-client-manner "Remote Procedure Call <RPC>"-technology based Proxy-FMU-functionalities,

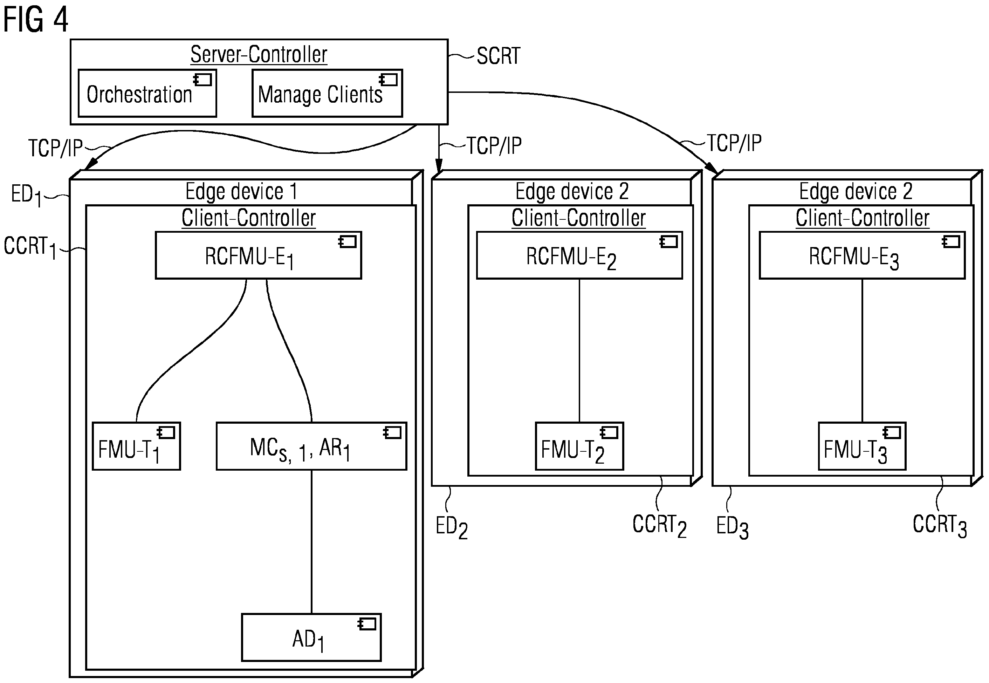

FIGURE 4 shows starting from the FIGURE 1 and based on the corresponding Figure-1-description an exemplary orchestration flow between involved units of the "SERVER-CLIENT"-based scenario depicted in the FIGURE 1. Between the server-controller SCRT including an orchestration entity responsible for the orchestration and manage-clients-entity responsible for managing clients the orchestration flow is TCP/IP-based (cf. https://en.wikipedia.org/wiki/Internet Protocol in *the version of July 25, 2021).*

## Claims

1. Computer-implemented method to orchestrate configurations of simulations based on digital twin models (DTM₁, DTM₂, DTM₃) of modular plants (Pₘ, PM₁, PM₂, PM₃), by which is used for the configurations of the model-based simulations
a) a logical "System Structure and Parameterization <SSP>"-functionality (SSP-T)
a1) describing in a logical way how
a11) model components for the simulations are connected and composed for their deployment into composite components and a12) model parameterization data are stored and exchanged between each the model component and the composite component and
a2) including a "Functional Mock-up Interface <FMI>"-functionality (FMI-T) for sharing the simulations via a "ZIP-archive"-based "Functional Mock-up Unit <FMU>"-functionality (FMU-T) packing XML-files and compiled C-code,
**characterized by**:
b) generating (grt) for distributed operational-technology-applications (OTA_{d}, ED₁, ED₂, ED₃) of the modular plants (Pₘ, PM₁, PM₂, PM₃), wherein the operational-technology-applications are edge devices (ED₁, ED₂, ED₃) of field devices (FD₁, FD₂, FD₃), simulated model components (MC_{s,1}, MC_{s,2}, MC_{s,3}) including assignment rules (AR₁, AR₂, AR₃) for automation data (AD₁, AD₂, AD₃) captured due to automation of the plants (Pₘ, PM₁, PM₂, PM₃) and assigned to the distributed operational-technology-applications (OTA_{d}, ED₁, ED₂, ED₃),
c) deploying (dpl) in the course of orchestrating the simulations configurations the simulated model components (MC_{s,1}, MC_{s,2}, MC_{s,3}) on the distributed operational-technology-applications (OTA_{d}, ED₁, ED₂, ED₃) by using the SSP-functionality (SSP-T) with "Functional Mock-up Unit <FMU>"-functionalities (FMU-T₁, FMU-T₂, FMU-T₃) as part of the FMI-functionality (FMI-T) for the distributed operational-technology-applications (OTA_{d}, ED₁, ED₂, ED₃) and implementing for the distributed operational-technology-applications (OTA_{d}, ED₁, ED₂, ED₃) and as part of the FMI-functionality (FMI-T) in a server-client-manner "Remote Procedure Call <RPC>"-technology based Proxy-FMU-functionalities (PFMU-T₁, PFMU-T₂, PEMU-T₃) with
- "Proxy-FMU"-entities (PFMU-E₁, PFMU-E₂, PFMU-E₃) embedded in the SSP-functionality (SSP-T) and
- corresponding "Remote-Controlled-FMU"-entities (RCFMU-E₁, RCFMU-E₂, RCFMU-E₃) implemented on the distributed operational-technology-applications (OTA_{d}, ED₁, ED₂, ED₃),
d) deploying (dpl) the automation data (AD₁, AD₂, AD₃) on the distributed operational-technology-applications (OTA_{d}, ED₁, ED₂, ED₃) according to the assignment rules (AR₁, AR₂, AR₃) for the automation data (AD₁, AD₂, AD₃) and as a result of the deployment (dpl) of the simulated model components (MC_{s,1}, MC_{s,2}, MC_{s,3})

2. Computer program product comprising instructions which, when the program is executed by a computer, cause the computer to carry out the computer-implemented method according to claim 1.

3. Orchestration system (OS) to orchestrate configurations of simulations based on digital twin models (DTM₁, DTM₂, DTM₃) of modular plants (Pₘ, PM₁, PM₂, PM₃), with a server-controller (SCRT) to configure the model-based simulations including
a) a logical "System Structure and Parameterization <SSP>"-tool (SSP-T)
a1) describing in a logical way how
a11) model components for the simulations are connected and composed for their deployment into composite components and a12) model parameterization data are stored and exchanged between each the model component and the composite component and
a2) including a "Functional Mock-up Interface <FMI>"-tool (FMI-T) for sharing the simulations via a "ZIP-archive"-based "Functional Mock-up Unit <FMU>"-tool (FMU-T) packing XML-files and compiled C-code,
b) a generation unit (GU) of the server-controller (SCRT) generating (grt) for distributed operational-technology-applications (OTA_{d}, ED₁, ED₂, ED₃) of the modular plants (Pₘ, PM₁, PM₂, PM₃), wherein the operational-technology-applications are edge devices (ED₁, ED₂, ED₃) of field devices (FD₁, FD₂, FD₃), simulated model components (MC_{s,1}, MC_{s,2}, MC_{s,3}) including assignment rules (AR₁, AR₂, AR₃) for automation data (AD₁, AD₂, AD₃) captured due to automation of the plants (Pₘ, PM₁, PM₂, PM₃) and assigned to the distributed operational-technology-applications (OTA_{d}, ED₁, ED₂, ED₃),
c) a deployment tool (DT) of the server-controller (SCRT) **characterized by**:
c1) deploying (dpl) in the course of orchestrating the simulations configurations the simulated model components (MC_{s,1}, MC_{s,2}, MC_{s,3}) on the distributed operational-technology-applications (OTA_{d}, ED₁, ED₂, ED₃) by using the SSP-functionality (SSP-T) with "Functional Mock-up Unit <FMU>"-functionalities (FMU-T₁, FMU-T₂, FMU-T₃) as part of the FMI-functionality (FMI-T) for the distributed operational-technology-applications (OTA_{d}, ED₁, ED₂, ED₃) and implementing for the distributed operational-technology-applications (OTA_{d}, ED₁, ED₂, ED₃) and as part of the FMI-functionality (FMI-T) in a server-client-manner "Remote Procedure Call <RPC>"-technology based Proxy-FMU-functionalities (PFMU-T₁, PFMU-T₂, PEMU-T₃) with
- "Proxy-FMU"-entities (PFMU-E₁, PFMU-E₂, PFMU-E₃) embedded in the SSP-functionality (SSP-T) of the server-controller (SCRT) and
- corresponding "Remote-Controlled-FMU"-entities (RCFMU-E₁, RCFMU-E₂, RCFMU-E₃) implemented on the distributed operational-technology-applications (OTA_{d}, ED₁, ED₂, ED₃) including client-controllers (CCRT₁, CCRT₂, CCRT₃),
c2) deploying (dpl) the automation data (AD₁, AD₂, AD₃) on the distributed operational-technology-applications (OTA_{d}, ED₁, ED₂, ED₃) according to the assignment rules (AR₁, AR₂, AR₃) for the automation data (AD₁, AD₂, AD₃) and as a result of the deployment (dpl) of the simulated model components (MC_{s,1}, MC_{s,2}, MC_{s,3}).

4. Orchestration system (OS), **characterized by** the Computer-Program-Product according to claim 2, e.g., designed as an APP, up-loadable into a server-controller (SCRT),
whereby a processor of the server controller (SCRT) is configured to executed the instructions of the uploaded Computer-Program-Product, causing the processor of the server-controller (SCRT) to orchestrate the simulations configurations.

## Patentansprüche

1. Computerimplementiertes Verfahren zur Orchestrierung von Konfigurationen von Simulationen auf der Basis von digitalen Zwillingsmodellen (DTM₁, DTM₂, DTM₃) von modularen Anlagen (Pₘ, PM₁, PM₂, PM₃), durch das für die Konfigurationen der modellbasierten Simulationen Folgendes verwendet wird
a) eine logische Funktionalität zur "Systemstruktur- und Parametrisierung <SSP>" (SSP-T)
a1) die in logischer Weise beschreibt, wie
a11) Modellkomponenten für die Simulationen verbunden und für ihre Bereitstellung zu Verbundkomponenten zusammengesetzt werden, und
a12) Modellparametrisierungsdaten gespeichert und zwischen jeder von der Modellkomponente und der Verbundkomponente ausgetauscht werden, und
a2) beinhaltend eine Funktionalität für eine "funktionale Mock-up-Schnittstelle <FMI>" (FMI-T) zur gemeinsamen Nutzung der Simulationen über eine "ZIP-Archiv"-basierte Funktionalität für eine "funktionale Mock-up-Einheit <FMU>" (FMU-T), die XML-Dateien und kompilierten C-Code enthält,
**gekennzeichnet durch**:
b) Generieren (grt) von simulierten Modellkomponenten (MC_{s,1}, MC_{s,2}, MC_{s,3}) für verteilte Betriebstechnik-Anwendungen (OTA_{d}, ED₁, ED₂, ED₃) der modularen Anlagen (Pₘ, PM₁, PM₂, PM₃), beinhaltend Zuordnungsregeln (AR₁, AR₂, AR₃) für Automatisierungsdaten (AD₁, AD₂, AD₃), die aufgrund einer Automatisierung der Anlagen (Pₘ, PM₁, PM₂, PM₃) erfasst und den verteilten Betriebstechnik-Anwendungen (OTA_{d}, ED₁, ED₂, ED₃) zugeordnet werden, wobei die Betriebstechnik-Anwendungen Edge-Vorrichtungen (ED₁, ED₂, ED₃) von Feldvorrichtungen (FD₁, FD₂, FD₃) sind,
c) Bereitstellen (dpl) der simulierten Modellkomponenten (MC_{S,1}, MC_{S,2}, MC_{s,3}) auf den verteilten Betriebstechnik-Anwendungen (OTA_{d}, ED₁, ED₂, ED₃) im Rahmen der Orchestrierung der Simulationskonfigurationen unter Verwendung der SSP-Funktionalität (SSP-T) mit Funktionalitäten für eine "funktionale Mock-up-Einheit <FMU>" (FMU-T₁, FMU-T₂, FMU-T₃) als Teil der FMI-Funktionalität (FMI-T) für die verteilten Betriebstechnik-Anwendungen (OTA_{d}, ED₁, ED₂, ED₃) und Implementieren von auf "Remote Procedure Call <RPC>"-Technologie basierenden Proxy-FMU-Funktionalitäten (PFMU-T₁, PFMU-T₂, PFMU-T₃) für die verteilten Betriebstechnik-Anwendungen (OTA_{d}, ED₁, ED₂, ED₃) und als Teil der FMI-Funktionalität (FMI-T) auf eine Server-Client-Art mit
- "Proxy-FMU"-Einheiten (PFMU-E₁, PFMU-E₂, PFMU-E₃), die in die SSP-Funktionalität (SSP-T) eingebettet sind, und
- entsprechenden "Remote-Controlled-FMU"-Einheiten (RCFMU-E₁, RCFMU-E₂, RCFMU-E₃), die auf den verteilten Betriebstechnik-Anwendungen (OTA_{d}, ED₁, ED₂, ED₃) implementiert sind,
d) Bereitstellen (dpl) der Automatisierungsdaten (AD₁, AD₂, AD₃) auf den verteilten Betriebstechnik-Anwendungen (OTA_{d}, ED₁, ED₂, ED₃) gemäß den Zuordnungsregeln (AR₁, AR₂, AR₃) für die Automatisierungsdaten (AD₁, AD₂, AD₃) und als Ergebnis der Bereitstellung (dpl) der simulierten Modellkomponenten (MC_{S,1}, MC_{S,2}, MC_{S,3}).

2. Computerprogrammprodukt, umfassend Anweisungen, die bei Ausführung des Programms durch einen Computer den Computer dazu veranlassen, das computerimplementierte Verfahren nach Anspruch 1 durchzuführen.

3. Orchestrierungssystem (OS) zur Orchestrierung von Konfigurationen von Simulationen auf der Basis von digitalen Zwillingsmodellen (DTM₁, DTM₂, DTM₃) von modularen Anlagen (Pₘ, PM₁, PM₂, PM₃) mit einer Serversteuerung (SCRT) zum Konfigurieren der modellbasierten Simulationen, beinhaltend
a) ein logisches Tool zur "Systemstruktur- und Parametrisierung <SSP>" (SSP-T)
a1) die in logischer Weise beschreibt, wie
a11) Modellkomponenten für die Simulationen verbunden und für ihre Bereitstellung zu Verbundkomponenten zusammengesetzt werden, und
a12) Modellparametrisierungsdaten gespeichert und zwischen jeder von der Modellkomponente und der Verbundkomponente ausgetauscht werden, und
a2) beinhaltend ein Tool für eine "funktionale Mock-up-Schnittstelle <FMI>" (FMI-T) zur gemeinsamen Nutzung der Simulationen über ein "ZIP-Archiv"-basiertes Tool für eine "funktionale Mock-up-Einheit <FMU>" (FMU-T), die XML-Dateien und kompilierten C-Code enthält,
**gekennzeichnet durch**:
b) eine Generierungseinheit (GU) der Serversteuerung (SCRT) zum Generieren (grt) von simulierten Modellkomponenten (MC_{S,1}, MC_{S,2}, MC_{s,3}) für verteilte Betriebstechnik-Anwendungen (OTA_{d}, ED₁, ED₂, ED₃) der modularen Anlagen (Pₘ, PM₁, PM₂, PM₃), beinhaltend Zuordnungsregeln (AR₁, AR₂, AR₃) für Automatisierungsdaten (AD₁, AD₂, AD₃), die aufgrund einer Automatisierung der Anlagen (Pₘ, PM₁, PM₂, PM₃) erfasst und den verteilten Betriebstechnik-Anwendungen (OTA_{d}, ED₁, ED₂, ED₃) zugeordnet werden, wobei die Betriebstechnik-Anwendungen Edge-Vorrichtungen (ED₁, ED₂, ED₃) von Feldvorrichtungen (FD₁, FD₂, FD₃) sind,
c) ein Bereitstellungstool (DT) der Serversteuerung (SCRT)
c1) Bereitstellen (dpl) der simulierten Modellkomponenten (MC_{S,1}, MC_{S,2}, MC_{s,3}) auf den verteilten Betriebstechnik-Anwendungen (OTA_{d}, ED₁, ED₂, ED₃) im Rahmen der Orchestrierung der Simulationskonfigurationen unter Verwendung der SSP-Funktionalität (SSP-T) mit Funktionalitäten für eine "funktionale Mock-up-Einheit <FMU>" (FMU-T₁, FMU-T₂, FMU-T₃) als Teil der FMI-Funktionalität (FMI-T) für die verteilten Betriebstechnik-Anwendungen (OTA_{d}, ED₁, ED₂, ED₃) und Implementieren von auf "Remote Procedure Call <RPC>"-Technologie basierenden Proxy-FMU-Funktionalitäten (PFMU-T₁, PFMU-T₂, PFMU-T₃) für die verteilten Betriebstechnik-Anwendungen (OTA_{d}, ED₁, ED₂, ED₃) und als Teil der FMI-Funktionalität (FMI-T) auf eine Server-Client-Art mit
- "Proxy-FMU"-Einheiten (PFMU-E₁, PFMU-E₂, PFMU-E₃), die in die SSP-Funktionalität (SSP-T) der Serversteuerung (SCRT) eingebettet sind, und
- entsprechenden "Remote-Controlled-FMU"-Einheiten (RCFMU-E₁, RCFMU-E₂, RCFMU-E₃), die auf den verteilten Betriebstechnik-Anwendungen (OTA_{d}, ED₁, ED₂, ED₃) implementiert sind, beinhaltend Client-Steuerungen (CCRT₁, CCRT₂, CCRT₃),
c2) Bereitstellen (dpl) der Automatisierungsdaten (AD₁, AD₂, AD₃) auf den verteilten Betriebstechnik-Anwendungen (OTA_{d}, ED₁, ED₂, ED₃) gemäß den Zuordnungsregeln (AR₁, AR₂, AR₃) für die Automatisierungsdaten (AD₁, AD₂, AD₃) und als Ergebnis der Bereitstellung (dpl) der simulierten Modellkomponenten (MC_{S,1}, MC_{S,2}, MC_{S,3}).

4. Orchestrierungssystem (OS), **gekennzeichnet durch** das Computerprogrammprodukt nach Anspruch 2, z. B. als APP ausgebildet, das in die Serversteuerung (SCRT) hochgeladen werden kann,
wobei ein Prozessor der Serversteuerung (SCRT) dazu konfiguriert ist, die Anweisungen des hochgeladenen Computerprogrammprodukts auszuführen, was den Prozessor der Serversteuerung (SCRT) dazu veranlasst, die Simulationskonfigurationen zu orchestrieren.

## Revendications

1. Procédé mis en œuvre par ordinateur pour orchestrer des configurations de simulations basées sur des modèles de jumeau numérique (DTM₁, DTM₂, DTM₃) d'installations modulaires (Pₘ, PM₁, PM₂, PM₃), par lequel, est utilisé pour les configurations des simulations basées sur des modèles,
a) une fonctionnalité « Structure et paramétrisation de système <SSP> » logique (SSP-T)
a1) décrivant d'une manière logique la manière dont a11) des composants de modèle pour les simulations sont reliés et composés pour leur déploiement en composants composites et a12) des données de paramétrisation de modèle sont stockées et échangées entre chacun parmi le composant de modèle et le composant composite et
a2) incluant une fonctionnalité « Interface de prototypage fonctionnel <FMI> » (FMI-T) pour le partage des simulations via une fonctionnalité « Unité de prototypage fonctionnel <FMU> » (FMU-T) basée sur une « archive ZIP » empaquetant des fichiers XML et du code C compilé,
**caractérisé par** :
b) la génération (grt) d'applications de technologie opérationnelle distribuée (OTA_{D}, ED₁, ED₂, ED₃) des installations modulaires (Pₘ, PM₁, PM₂, PM₃), dans lequel les applications de technologie opérationnelle sont des dispositifs périphériques (ED₁, ED₂, ED₃) de dispositifs de terrain (FD₁, FD₂, FD₃), des composants de modèle simulés (MC_{s,1}, MC_{s,2}, MC_{s,3}) incluant des règles d'attribution (AR₁, AR₂, AR₃) pour des données d'automatisation (AD₁, AD₂, AD₃) capturées en raison de l'automatisation des installations (Pₘ, PM₁, PM₂, PM₃) et attribuées aux applications de technologie opérationnelle distribuée (OTA_{d}, ED₁, ED₂, ED₃),
c) le déploiement (dpl), au cours de l'orchestration des configurations de simulation, des composants de modèle simulés (MC_{s,1}, MC_{s,2}, MC_{s,3}) sur les applications de technologie opérationnelle distribuée (OTA_{d}, ED₁, ED₂, ED₃) en utilisant la fonctionnalité SSP (SSP-T) avec des fonctionnalités « Unité de prototypage fonctionnel <FMU> » (FMU-T₁, FMU-T₂, FMU-T₃) dans le cadre de la fonctionnalité FMI (FMI-T) pour les applications de technologie opérationnelle distribuée (OTA_{d}, ED₁, ED₂, ED₃) et la mise en œuvre des applications de technologie opérationnelle distribuée (OTA_{d}, ED₁, ED₂, ED₃) et dans le cadre de la fonctionnalité FMI (FMI-T) d'une manière client-serveur de fonctionnalités Proxy-FMU basées sur une technologie « Appel de procédure à distance <RPC> » (PFMU-T₁, PFMU-T₂, PFMU-T₃) avec
- des entités « Proxy-FMU » (PFMU-F₁, PFMU-E₂, PFMU-E₃) incorporées dans la fonctionnalité SSP (SSP-T) et
- des entités « FMU commandées à distance » correspondantes (RCFMU-E₁, RCFMU-E₂, RCFMU-E₃) mises en œuvre sur les applications de technologie opérationnelle distribuée (OTA_{d}, ED₁, ED₂, ED₃),
d) le déploiement (dpl) des données d'automatisation (AD₁, AD₂, AD₃) sur les applications de technologie opérationnelle distribuée (OTA_{d}, ED₁, ED₂, ED₃) selon les règles d'attribution (AR₁, AR₂, AR₃) pour les données d'automatisation (AD₁, AD₂, AD₃) et en conséquence du déploiement (dpl) des composants de modèle simulés (MC_{s,1}, MC_{s,2}, MC_{s,3})

2. Produit programme d'ordinateur comprenant des instructions qui, lorsque le programme est exécuté par un ordinateur, amènent l'ordinateur à effectuer le procédé mis en œuvre par ordinateur selon la revendication 1.

3. Système d'orchestration (OS) pour orchestrer des configurations de simulations basées sur des modèles de jumeau numérique (DTM₁, DTM₂, DTM₃) d'installations modulaires (Pₘ, PM₁, PM₂, PM₃), avec un serveur-contrôleur (SCRT) pour configurer les simulations basées sur des modèles incluant
a) un outil « Structure et paramétrisation de système <SSP> » logique (SSP-T)
a1) décrivant d'une manière logique la manière dont a11) des composants de modèle pour les simulations sont reliés et composés pour leur déploiement en composants composites et a12) des données de paramétrisation de modèle sont stockées et échangées entre chacun parmi le composant de modèle et le composant composite et
a2) incluant un outil « Interface de prototypage fonctionnel <FMI> » (FMI-T) pour le partage des simulations via un outil « Unité de prototypage fonctionnel <FMU> » (FMU-T) basée sur une « archive ZIP » empaquetant des fichiers XML et du code C compilé,
**caractérisé par** :
b) une unité de génération (GU) du serveur-contrôleur (SCRT) générant (grt) des applications de technologie opérationnelle distribuée (OTA_{d}, ED₁, ED₂, ED₃) des installations modulaires (Pₘ, PM₁, PM₂, PM₃), dans lequel les applications de technologie opérationnelle sont des dispositifs périphériques (ED₁, ED₂, ED₃) de dispositifs de terrain (FD₁, FD₂, FD₃), des composants de modèle simulés (MC_{s,1}, MC_{s,2}, MC_{s,3}) incluant des règles d'attribution (AR₁, AR₂, AR₃) pour des données d'automatisation (AD₁, AD₂, AD₃) capturées en raison de l'automatisation des installations (Pₘ, PM₁, PM₂, PM₃) et attribuées aux applications de technologie opérationnelle distribuée (OTA_{d}, ED₁, ED₂, ED₃),
c) un outil de déploiement (DT) du serveur-contrôleur (SCRT) c1) déployant (dpl), au cours de l'orchestration des configurations de simulation, des composants de modèle simulés (MC_{s,1}, MC_{s,2}, MC_{s,3}) sur les applications de technologie opérationnelle distribuée (OTA_{d}, ED₁, ED₂, ED₃) en utilisant la fonctionnalité SSP (SSP-T) avec des fonctionnalités « Unité de prototypage fonctionnel <FMU> » (FMU-T₁, FMU-T₂, FMU-T₃) dans le cadre de la fonctionnalité FMI (FMI-T) pour les applications de technologie opérationnelle distribuée (OTA_{d}, ED₁, ED₂, ED₃) et la mise en œuvre des applications de technologie opérationnelle distribuée (OTA_{d}, ED₁, ED₂, ED₃) et dans le cadre de la fonctionnalité FMI (FMI-T) d'une manière client-serveur de fonctionnalités Proxy-EMU basées sur une technologie « Appel de procédure à distance <RPC> » (PFMU-T₁, PFMU-T₂, PFMU-T₃) avec
- des entités « Proxy-FMU » (PFMU-F₁, PFMU-E₂, PFMU-E₃) incorporées dans la fonctionnalité SSP (SSP-T) du serveur-contrôleur (SCRT) et
- des entités « FMU commandées à distance » correspondantes (RCFMU-E₁, RCFMU-E₂, RCFMU-E₃) mises en œuvre sur les applications de technologie opérationnelle distribuée (OTA_{d}, ED₁, ED₂, ED₃) incluant des clients-contrôleurs (CCRT₁, CCRT₂, CCRT₃), c2) déployant (dpl) les données d'automatisation (AD₁, AD₂, AD₃) sur les applications de technologie opérationnelle distribuée (OTA_{d}, ED₁, ED₂, ED₃) selon les règles d'attribution (AR₁ AR₂, AR₃) pour les données d'automatisation (AD₁, AD₂, AD₃) et en conséquence du déploiement (dpl) des composants de modèle simulés (MC_{s,1}, MC_{s,2}, MC_{s,3})

4. Système d'orchestration (OS), **caractérisé par** le produit programme d'ordinateur selon la revendication 2, par ex., conçu sous la forme d'une APP, apte à être téléchargé dans un serveur-contrôleur (SCRT),
dans lequel un processeur du serveur-contrôleur (SCRT) est configuré pour exécuter les instructions du produit programme d'ordinateur téléchargé, amenant le processeur du serveur-contrôleur (SCRT) à orchestrer les configurations de simulations.
